# EUROPEAN PATENT APPLICATION

(11) **EP 2 400 344 A1**
(43) Date of publication of application: **28.12.2011**
(21) Application number: 11166082.5
(22) Date of filing: 13.05.2011
(51) Int. Cl.: G03F 7/023, H05K 3/10

(54) **Positive photosensitive resin composition**

(30) Priority: 28.06.2010 TW 099121014
(71) Applicant: Everlight USA, Inc., Pineville, North Carolina 28134 (US)
(72) Inventor: Li, Yen-Cheng, Taoyuan 328 (TW); Chou, Nai-Tien, Taoyuan 328 (TW); Wei, Jung-Hsin, Taoyuan 328 (TW)
(74) Representative: Epping - Hermann - Fischer

(57) **Abstract**

The present invention provides a positive photosensitive resin composition, including an alkali soluble phenolic resin; an alkali soluble acrylic resin; and a photosensitive compound having quinone diazide. The positive photosensitive resin composition is applicable to a semi-additive process for forming tiny and fine wirings.

## Description

### 1. Field of Invention

The present invention relates to a positive photosensitive resin composition, and more particularly, to a positive photosensitive resin composition for a semi-additive process.

### 2. Background of the Invention

In a conventional printed circuit plate, a metal layer on a substrate is etched by a subtractive process to form a wiring pattern. However, it is the trend to microminiaturize an electronic product, and thus it is very important to reduce the pitch between wirings to increase product density while making a circuit board plate. Therefore, an additive process is developed to form a wiring pattern on a substrate by electroplating in order to overcome instability during fabrication of wirings with tiny pitch. The additive process includes a full-additive process and a semi-additive process. In the full-additive process, a photoresist is applied on an insulation layer of a substrate and patterned by lithography to form a plating resist; a wiring pattern is formed on the insulation layer exposing from the plating resist; and the photoresist is removed by etching. In the semi-additive process, a thin metal layer is formed on an insulation layer of a substrate; a photoresist is applied on the thin metal layer; the photoresist is patterned by lithography to form a plating resist; a wiring pattern is formed on the thin metal layer exposing from the plating resist; and the photoresist and the thin metal layer beneath the photoresist is removed. Taiwanese Patent No. I312649 discloses a method for fabricating a printed circuit board by a semi-additive process.

Currently, the semi-additive process is widely used, and a negative photoresist is used for forming a wiring pattern of a circuit board plate. Upon light exposure, the negative photoresist produces cross links and is hard to be dissolved in a developing solution. Hence, during lithography, the negative photoresist (non-exposed portion) masked by a mask is dissolved in the developing solution and then removed. Taiwanese Patent Application Publication No. 200906259 discloses using a negative photoresist in a semi-additive process for forming wirings with a pitch less than 40 µm (wiring width/pitch = 20/20 µm). The negative photoresist includes a dry film photoresist and a liquid photoresist. The dry film photoresist is a thin film attached on a substrate. The dry film photoresist is convenient, but has poor attachment to the substrate and poor resolution. The liquid photoresist is a solution for being applied on a substrate and dried to form a thin film, and thus has better attachment to an insulation layer on a substrate or a thin metal layer and has better resolution. Taiwanese Patent No.I226089 discloses a dry film photoresist applied in a semi-additive process. Taiwanese Patent Application Publication No. 200704297 discloses a liquid negative photoresist applied in a semi-additive process. Taiwanese Patent Application Publication No. 200501852 discloses using a liquid and a dry film negative photoresists in a semi-additive process to form wirings with wiring width/pitch = 15/15 µm (as illustrated in Embodiment 1 and Embodiment 2).

However, the conventional photoresist easily crack or has poor attachment to an insulation layer on a substrate or to a thin metal layer, such that electroplating material penetrates under electroplating resist or makes stripping of the electroplating resist, and thus makes the formation of a wiring pattern failed. Further, the conventional photoresist has poor contrast or poor resistance to corrosion of electroplating solution, and thus easily forms poor wiring shapes. In addition, while forming wirings with high resolution (for example, wiring pitch less than 12 µm), the conventional negative photoresist fails to meet such requirement due to the technical limitation, or needs expensive equipment to form wirings with high resolution.

Accordingly, there is a need to develop a photoresist with great capability of attachment and great tolerance to electroplating for being applied in a semi-additive process to form tiny wirings.

### SUMMARY OF THE INVENTION

The present invention provides a positive photosensitive resin composition, including: 20 to 40 wt% of an alkali soluble phenolic resin based on total weight of the positive photosensitive resin composition, wherein the alkali soluble phenolic resin has an average molecular weight of 8000 to 30000; 5 to 20 wt% of an alkali soluble acrylic resin based on the total weight of the positive photosensitive resin composition, wherein the alkali soluble acrylic resin has an average molecular weight of 5000 to 55000; 1 to 15 wt% of a photosensitive compound having quinone diazide based on the total weight of the positive photosensitive resin composition; and a solvent.

According to an embodiment of the present invention, the alkali soluble acrylic resin includes units of formulae (I), (II) and (III):

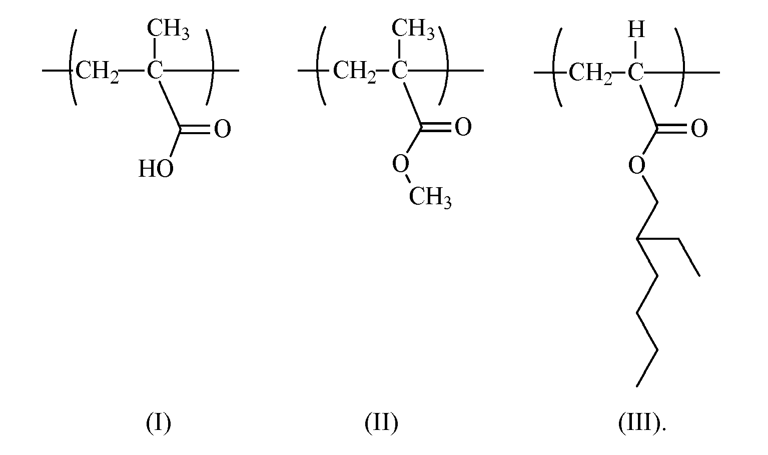

The photosensitive compound having quinone diazide is formed from naphthoquinone diazide salfonic acid and a compound of formula (C-1), (C-2), (C-3) or (C-4):

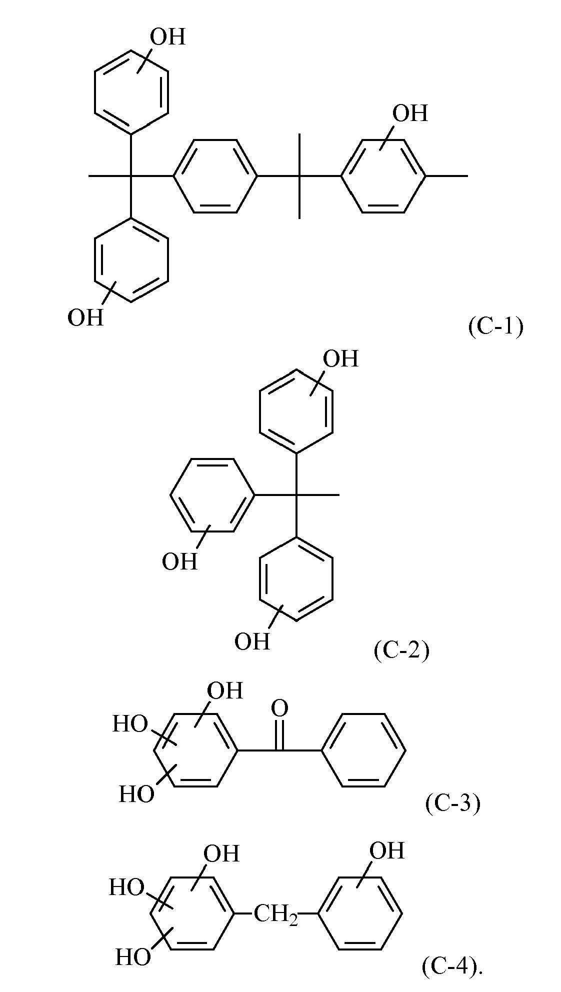

According to the present invention, the positive photosensitive resin composition incudes 1 to 30 wt%, preferably 1 to 20 wt%, and more preferably 1 to 15 wt% of the photosensitive compound having quinone diazide.

The positive photosensitive resin composition incudes an alkali soluble phenolic resin, an alkali soluble acrylic resin and a photosensitive compound having quinone diazide, and thus is suitable for a semi-additive process. The positive photosensitive resin composition of the present invention may be used in a semi-additive process for forming a tiny wiring, and has great capability of attachment and great tolerance to electroplating.

### DETAILED DESCRIPTION OF THE PREFERED EMBODIMENTS

The following specific examples are used for illustrating the present invention. A person skilled in the art can easily conceive the other advantages and effects of the present invention.

The positive photosensitive resin composition of the present invention for a semi-additive process includes: an alkali soluble phenolic resin; an alkali soluble acrylic resin; a photosensitive compound having quinone diazide; and a solvent.

In the positive photosensitive resin composition, the average molecular weight of the alkali soluble phenolic resin is 8000 to 30000.

The term "average molecular weight" herein refers to a measured value of a sample in a tetrahydrofuran relative to a polystyrene standard by gel penetration chromatography (GPC).

In the positive photosensitive resin composition, the alkali soluble phenolic resin is 20 to 40 wt%, and preferably 25 to 3 5wt%, based on the positive photosensitive resin composition.

Conventionally, the alkali soluble phenolic resin may be formed from an additive condensation reaction of a phenolic hydroxyl aromatic compound (phenolic, hereafter) and an aldehyde. The preparation method of the alkali soluble phenolic resin is well known to persons skilled in the art, and thus to be omitted herein.

The phenolic compound may be, but not limited to, phenol, o-cresol, p-cresol, 2-ethylphenol, 3-ethylphenol, 4-ethylphenol, 2-butylphenol, 3-butylphenol, 4-butylphenol, 2,3-dimethylphenol, 2,4-dimethylphenol, 2,5-dimethylphenol, 2,6-dimethylphenol, 3,4-dimethylphenol, 3,5-dimethylphenol, 2,3,5-trimethylphenol, 3,4,5-trimethylphenol, p-phenylphenol, resorcinol, hydroquinone, hydroquinone-methyl ether, pyrogallol,phloroglucinol, hydroxy biphenyl, bisphenol A, gallic acid, gallate, α-naphthol or β-naphthol. The aldehyde may be (but not limited to) formaldehyde, paraformaldehyde, furylaldehyde, benzaldehyde, nitrobenzaldehyde or acetaldehyde.

In one embodiment, the alkali soluble phenolic resin has a phenyl repeat unit with a methyl group and a hydroxyl group, and the methyl group and the hydroxyl group are meta or para positions. The alkali soluble phenolic resin may be formed from at least two phenolic resins. For example, the alkali soluble phenolic resin may be formed from a first phenolic resin and a second phenolic resin.

The term "acrylic resin" herein includes an acrylic resin and a methylacrylic resin. The term "(methyl)acrylic" refers to acrylic and methylacrylic.

In the positive photosensitive resin composition, the average molecular weight of the alkali soluble acrylic resin is 5000 to 55000, and preferably 10000 to 25000. In one embodiment, the average molecular weight of the alkali soluble acrylic resin is 20000 to 35000.

In the positive photosensitive resin composition, the alkali soluble acrylic resin is 5 to 20 wt%, and preferably 10 to 20 wt%. When the amount of the alkali soluble acrylic resin is less than 5 wt%, the composition has poor tolerance to electroplating, and thus penetration and cracks easily occur. When the amount of the alkali soluble acrylic resin is more than 30 wt%, the composition has lower contrast and thus results in poor wiring patterns.

In the positive photosensitive resin composition, the alkali soluble acrylic resin is preferably an acrylic resin formed from polymerization or copolymerization of ethylene unsaturated acid, and is more preferably a copolymer of ethylene unsaturated acid and units containing ethylene unsaturated bonds.

The ethylene unsaturated acid may be, but not limited to, (methyl)acrylic acid, crotonic acid, cis-butenedioic acid, fumaric acid, citroconic acid, methylfumaric acid, itaconic acid, hexanedioic acid or a combination thereof.

In one embodiment of the present invention, the ethylene unsaturated acid is (methyl) acrylic acid. According to one embodiment, the alkali soluble acrylic resin includes at least one ethylene unsaturated acid.

The unit having an ethylene unsaturated bond may be, but not limited to, a substituted or unsubstituted (methyl)acrylic C₁-C₁₈alkylester, and preferably a substituted or unsubstituted (methyl)acrylic C₁-C₈alkylester. According to one embodiment of the present invention, the alkali soluble acrylic resin may include at least one unit having ethylene unsaturated bonds.

In one embodiment of the present invention, the alkali soluble acrylic resin of the composition includes the units of formulae (I), (II) and (III):

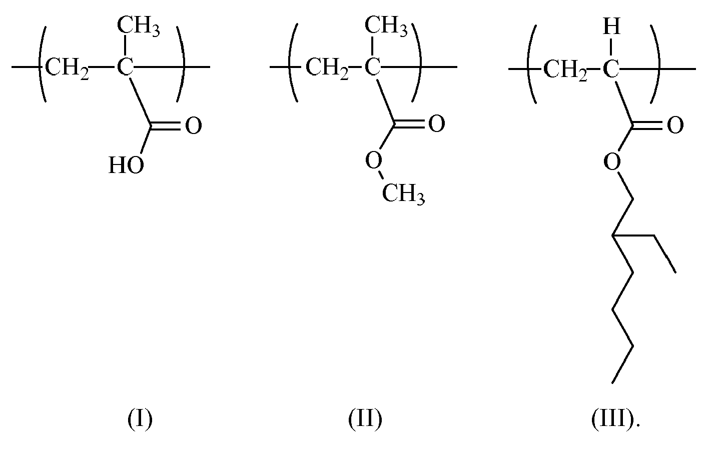

In one embodiment, the alkali soluble acrylic resin includes 5 to 50 wt%, and preferably 10 to 30 wt%, of the unit of formula (I). When the alkali soluble acrylic resin includes less than 5 wt% of the unit of formula (I), the composition has lower solubility in an alkali developing solution. When the alkali soluble acrylic resin includes more than 50 wt% of the unit of formula (I), the composition has too great solubility, such that while in an alkali developing solution, resist patterns easily peel off a substrate and the patterns are easily disrupted. The alkali soluble acrylic resin includes 40 to 90 wt%, and preferably 50 to 80 wt%, of the unit of formula (II). When the alkali soluble acrylic resin includes less than 40 wt% of the unit of formula (II), the composition has poor tolerance to electroplating, and penetration and cracks easily occur. When the alkali soluble acrylic resin includes more than 80 wt% of the unit of formula (II), the composition has lower solubility in an alkali developing solution. The alkali soluble acrylic resin includes 5 to 30 wt%, and preferably 10 to 20 wt%, of the unit of formula (III). When the alkali soluble acrylic resin includes less than 5 wt% of the unit of formula (III), the composition has poor tolerance to electroplating, and penetration and cracks easily occur. When the alkali soluble acrylic resin includes more than 20 wt% of the unit of formula (II), the composition has lower solubility in an alkali developing solution.

In the positive photosensitive resin composition, the photosensitive compound having quinone diazide is formed from an esterification of naphthoquinone diazide sulfonic acid compound and a compound having at least one phenolic hydroxyl group such as 1,2-naphthoquinonediazide-4-sulfonic acid or 1,2-naphthoquinonediazide-5-sulfonic acid.

The positive photosensitive resin composition may have single photosensitive compound having quinone diazide or have at least two different photosensitive compound having quinone diazides.

Preferably, the photosensitive compound having quinone diazide is an ester formed from 1,2-naphtoquinonediazide sulfonic acid and a polyhydric phenol having a hydroxyl group. For example, the photosensitive compound having quinone diazide may be an ester formed from 1,2-naphthoquinonediazide sulfonic acid and 2,3,4-triydroxylbenzophenone, di(4-hydroxyl-2,5-dimethylphenyl)-3,4-dihydroxyl phenylmethane, 1,1,1-tri(4-hydroxylphenyl)ethane, 4,4'-[1-[4[1-(4-hdroxylphenyl)-1-methylethyl]phenyl]ethylidene]bisphenol, or 2,3,4,4'-tetrahydroxyldiphenylmethane. In one embodiment of the present invention, the composition includes at least one compound containing quinone diazide.

In one embodiment of the present invention, the photosensitive compound having quinone diazide includes a sulfonate ester formed from 1,2-naphthodiazide-4-sulfonic acid, 1,2-naphthodiazide-5-sulfonic acid, and the compounds of formulae (C-1), (C-2), (C-3) and (C-4):

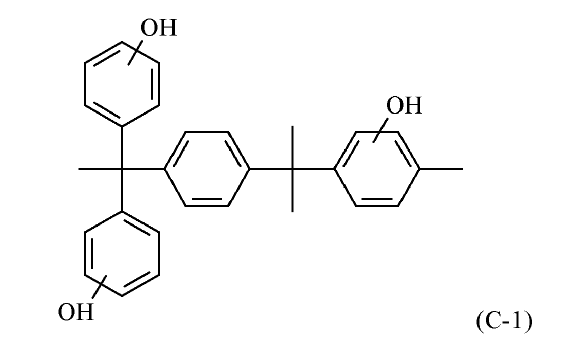

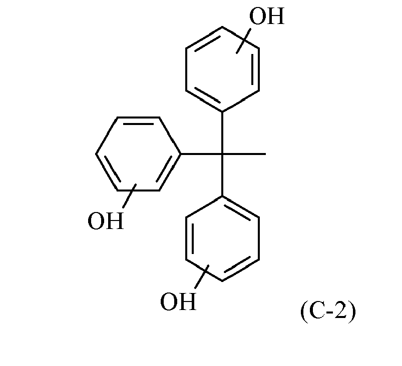

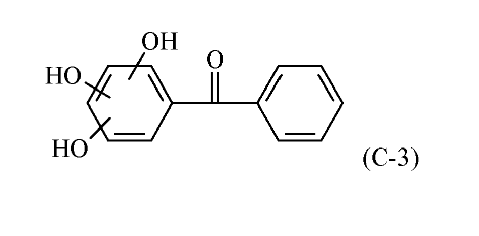

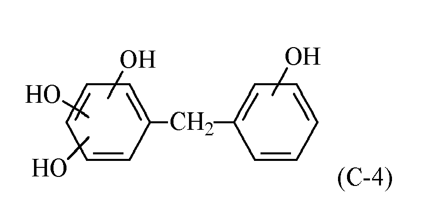

The positive photosensitive resin composition includes 1 to 30 wt%, preferably 1 to 20 wt%, and more preferably 1 to 15 wt% of the photosensitive compound having quinone diazide. When the composition includes less than 1 wt% of the photosensitive compound having quinone diazide, the composition cannot form wiring patterns upon development due to insufficient photosensitization. When the composition includes more than 30 wt% of the photosensitive compound having quinone diazide, the composition has lower contrast, and thus forms poor wiring patterns upon development.

In one embodiment of the present invention, the positive photosensitive resin composition includes a solvent to form a liquid composition. The solvent is not limited, but needs to disperse or dissolve the composition without having reaction with components of the composition.

In one embodiment of the present invention, the positive photosensitive resin composition includes 20 to 90 wt%, preferably 25 to 80 wt%, and more preferably 25 to 74 wt% of a solvent.

The solvent may be, but not limited to, an ether such as ethylene glycol monomethyl ether, ethylene glycol monoethyl ether, ethylene glycol monopropyl ether, ethylene glycol monobutyl ether, diethylene glycol monomethyl ether, diethylene glycol monoethyl ether, diethylene glycol monopropyl ether, diethylene glycol monobutyl ether, triethylene glycol monomethyl ether, triethylene glycol monoethyl ether, propylene glycol monomethyl ether, propylene glycol monoethyl ether, propylene glycol monopropyl ether, propylene glycol monobutyl ether, dipropylene glycol monomethyl ether, dipropylene glycol monoethyl ether, dipropylne glycol monopropyl ether, dipropylne glycol monobutyl ether, tripropylene glycol monomethyl ether, tripropylene glycol monoethyl ether, diethylene glycol dimethyl ether, diethylene glycol methylethyl ether, diethylene glycol diethyl ether and tetrahydrofuran; a ketone such as methyl ethyl ketone, cyclohexanone, 2-heptanone and 3-heptanone; an ester such as ethylene glycol monomethyl ether acetate, ethylene glycol monoethyl ether acetate, diethylene glycol monomethyl ether acetate, diethylene glycol monoethyl ether acetate, propylene glycol monoethyl ether acetate, propylene glycol monomethyl ether acetate (PGMEA), 2-hydroxy-propionic acid methyl ester, 2-hydroxy-propionic acid ethyl ester, 2-hydroxy-2-methylpropionic acid ethyl ester, 3-methoxypropionic acid methyl ester, 3-methoxypropionic acid ethyl ester, 3-ethoxypropionic acid methyl ester, 3-ethoxypropionic acid ethyl ester, ethoxyacetic acid ethyl ester, hydroxyacetic acid ethyl ester, 2-hydroxy-3-methylbutanoic acid methyl ester, 3-methyl-3-methoxybutylacetate, 3-methyl-3-methoxybutylpropanate, ethyl acetate, propyl acetate, isopropyl acetate, butyl acetate, isobutyl acetate, pentyl formate, isopentyl acetate, butyl propionate, ethyl butyrate, propyl butyrate, isopropyl butyrate, butyl butyrate, methyl pyruvate, ethyl pyruvate, propyl pyruvate, methyl acetoacetate, ethyl acetoacetate and 2-hydroxyethylbutyrate; an aromatic compound such as toluene and xylene; and an amide such as N-methylpyrrolidone, N,N-dimethylformamide and N,N-dimethylacetamide. In one embodiment of the present invention, the composition includes at least one of the previous solvents.

In addition, the previous solvents may be used with benzyl ethyl ether, hexyl ether, acetonitrile acetone, isophorone, caproic acid, heptanoic acid, 1-octanol, 1-naphthol, benzyl alcohol, benzyl acetate, ethyl benzoate, diethyl oxalate, diethyl maleate, γ-butyrolactone, ethylene carbonate, propylene carbonate, ethylene glycol monophenylether acetate which have high boiling points.

In one embodiment of the present invention, the positive photosensitive resin composition may include an additive. The additive may be, but not limited to, a pigment, a dye, a dissolution inhibitor, a surfactant (such as fluoro-surfactant), a thermal polymer inhibitor, a thickener, an antifoaming agent, a sensitizer, an antioxidant and a coupling agent. The positive photosensitive resin composition includes no more than 5 wt% of the additive.

When the positive photosensitive resin composition of the present invention is used in a semi-additive process, the positive photosensitive resin composition may be formed on a substrate.

When the positive photosensitive resin composition is used for forming wirings, the positive photosensitive resin composition may be formed on a substrate, and the positive photosensitive resin composition is patterned for forming metal wirings.

### Embodiments

### Synthesis Examples

### (A) Synthesis of an alkali soluble phenolic resin

30 g of a phenolic resin (formed from the condensation of p-cresol (100 g), m-cresol (100 g) and 37% formaldehyde (120 g) with an oxalic acid catalyst; average molecular weight being about 20000) were used. This copolymer was the alkali soluble phenolic resin (a).

### (B) Synthesis of an alkali soluble acrylic resin

Nitrogen replacement was performed with a flask having a condenser with solid carbon dioxide/methanol and a thermometer, then 3.0 g of 2,2'-azobis(2-methylpropionitrile) (AIBN) and 225 g of ethyl 2-hydroxypropionate were added and stirred until the polymerization initiator was dissolved. 20 g of methylacrylic acid, 70 g of methyl methacrylate and 10 g of 2-ethyl hexyl acrylate were units for polymerization. The mixture was stirred slowly. The polymerization was performed at 80°C for 4 hours. After the temperature was cool down to the room temperature, the gas in the flask was replaced with air, and then 150 mg of p-methoxy phenol was added as a stabilizer. Methanol was dropped to the product to solidify the product. The solid product was washed by water, then re-dissolved with equal weight of tetrahydrofuran to the solid product, and further re-solidified by methanol. After the re-dissolution/re-solidification was performed for three times, the solid product was dried under vacuum at 40°C for 48 hours, and the acrylic copolymer (average molecular weight being about 30000) was obtained. The copolymer was the acrylic resin (b).

### (C) Synthesis of a photosensitive compound having quinone diazide

### (C1): TPPA photosensitive compound

The esterification of 1.0 mole of (4,4'-[1-[4-[1-(4-hydroxyphenyl)-1-methylethyl]phenyl]ethylidene] bisphenol) and 2.0 moles of naphthol-1,2-diazide-4-sulfonate chloride was performed, and the product was TPPA photosensitive compound.

### (C2): THPE photosensitive compound

The esterification of 1.0 mole of 1,1,1-tris(p-hydroxyphenyl)ethane and 2.0 moles of naphthol-1,2-diazide-5-sulfonate chloride was performed, and the product was THPE photosensitive compound.

### (C3): MAC-4 photosensitive compound

The esterification of 1.0 mole of 2,3,4-Tri-hydroxy-benzophenone and 2.0 moles of naphthol-1,2-diazide-4-sulfonate chloride was performed, and the product was MAC-4 photosensitive compound.

### (C4): THDM photosensitive compound

The esterification of 1.0 mole of 2,3,4,4'-Tetrahydroxydiphenylmethane and 2.0 moles of naphthol-1,2-diazide-5-sulfonate chloride was performed, and the product was THDM photosensitive compound.

### Preparation of a photosensitive resin composition

### Embodiment 1

30 g of the alkali soluble phenolic resin (a), 16 g of the acrylic resin (b), 6 g of the photosensitive compound TPPA and 48 g of propylene glycol monomethyl ether acetate (PGMEA) were mixed well, and filtered with a filter (10 µm), so as to form 100 g of the photosensitive resin composition.

### Embodiments 2-9

The steps in Embodiment 1 were repeated, and the components of the photoresist compositions in Embodiments 2-9 were as shown in Table 1.

### Comparative Example 1

The steps in Embodiment 1 were repeated, and the components of the photoresist composition in Comparative Example 1 were as shown in Table 1.

**Table 1**

| Embodiment | Alkali soluble phenolic resin (a) | Alkali soluble acrylic resin (b) | Photosensitive compound having quinone diazide | Solvent (PGMEA) |
|---|---|---|---|---|
| Embodiment 1 | 30 g | 16 g | 6 g of TPPA | 48 g |
| Embodiment 2 | 30 g | 8g | 6 g of TPPA | 56 g |
| Embodiment 3 | 30 g | 16 g | 6 g of TPPA | 48 g |
| Embodiment 4 | 30 g | 8g | 4.5 g of TPPA 1.5 g of THPE | 56 g |
| Embodiment 5 | 30 g | 8g | 3 g of TPPA 3 g of THPE | 56 g |
| Embodiment 6 | 30 g | 16 g | 6 g of MAC-4 | 48 g |
| Embodiment 7 | 30 g | 8 g | 6 g of MAC-4 | 56 g |
| Embodiment 8 | 30 g | 16 g | 6 g of THDM | 48 g |
| Embodiment 9 | 30 g | 8g | 6 g of THDM | 56 g |
| Comparative Example 1 | 30 g | - | 6 g of TPPA | 64 g |

### Evaluation of characteristics:

The photosensitive resin compositions of the above Embodiments and Comparative Example were tested to determine the wiring profile, the wiring pitch, exposure energy, attachment capability and tolerance to electroplating.

### Each of the photosensitive resin compositions of the above Embodiments and Comparative Example was coated on a copper film substrate by a spin coater. The rotation speed of the spin coater was controlled, such that the thickness of the coated film was 9 to 11 µm after the composition was baked in the oven at 100°C for 15 minutes. Then, the composition was taken out from the oven, and placed at the room temperature for 1 hour. The exposure was performed with a mask by a contact exposure machine (GPE-5K, Group Up Industrial Co., Ltd.) The development was performed by dipping in EPD2000 (2.38 wt% TMAH containing a surfactant) at 23°C. The tests were then performed, and the results were shown in Table 2. The symbols in Table 2 are illustrated as follows.

### (1) Wiring profile

After the development, the composition was cut and observed by SEM, and the top width and the bottom width were measured.
⊚ : the top width divided by the bottom width >0.83
○ : the top width divided by the bottom width in a range from 0.70 to 0.83
Δ : the top width divided by the bottom width in a range from 0.60 to 0.69
X: the top width divided by the bottom width < 0.60 or peeling

### (2) Wiring pitch

After the development, the composition was cut, and the wiring pitch was observed by SEM (S-4200, Hitachi).
○ : wiring pitch less than 6 µm
X: wiring pitch more than 6 µm or peeling

### (3) Exposure energy

The photosensitive resin composition was coated on a copper film substrate by a spin coater. The rotation speed of the spin coater was controlled, such that the thickness of the coated film was 9 to 11 µm after the composition was baked in the oven at 100°C for 15 minutes. Then, the composition was taken out from the oven, and placed at the room temperature for 1 hour. The exposure was performed with a mask by a contact exposure machine (GPE-5K, Group Up Industrial Co., Ltd.) When the exposure energy (mj) is too much, the production rate would be too slow to form products.
⊚ : exposure energy <190 mj
○ : exposure energy in a range from 190 mj to 220 mj
Δ : exposure energy in a range from 221 mj to 250 mj
sX: exposure energy >250 mj

### (4) Attachment capability

The photosensitive resin composition was coated on a copper film substrate by a spin coater. The rotation speed of the spin coater was controlled, such that the thickness of the coated film was 9 to 11 µm after the composition was baked in the oven at 100°C for 15 minutes. Then, the composition was taken out from the oven, and placed at the room temperature for 1 hour. The exposure was performed with a mask by a contact exposure machine (GPE-5K, Group Up Industrial Co., Ltd.) The development was performed by dipping in EPD2000 (2.38 wt% TMAH containing a surfactant) at 23°C. After the development, electroplating of copper and gold Au(CN)₂ series) was tested, and then the composition was observed by SEM (S-4200, Hitachi) to determine whether the bottom of the composition warps due to penetration.
○ : no penetration, no warps
X: penetration

### (5) Tolerance to electroplating

The photosensitive resin composition was coated on a copper film substrate by a spin coater. The rotation speed of the spin coater was controlled, such that the thickness of the coated film was 9 to 11 µm after the composition was baked in the oven at 100°C for 15 minutes. Then, the composition was taken out from the oven, and placed at the room temperature for 1 hour. The exposure was performed with a mask by a contact exposure machine (GPE-5K, Group Up Industrial Co., Ltd.) The development was performed by dipping in EPD2000 (2.38 wt% TMAH containing a surfactant) at 23°C. After the development, electroplating of copper and gold Au(CN)₂ series) was tested, and then the composition was observed by SEM (S-4200, Hitachi) to determine whether the surface of the composition cracks.
○ : no cracks
X: cracks

The results of the tests are shown in Table 2.

**Table 2**

| Embodiment | Wiring profile | Wiring pitch | Exposure energy | Attachment capability | Tolerance to electroplating |
|---|---|---|---|---|---|
| Embodiment 1 | Δ | ○ | Δ | ○ | ○ |
| Embodiment 2 | ○ | ○ | Δ | ○ | ○ |
| Embodiment 3 | ○ | ○ | ○ | ○ | ○ |
| Embodiment 4 | ⊚ | ○ | ○ | ○ | ○ |
| Embodiment 5 | ⊚ | ○ | ○ | ○ | ○ |
| Embodiment 6 | ○ | ○ | Δ | ○ | ○ |
| Embodiment 7 | ⊚ | ○ | ○ | ○ | ○ |
| Embodiment 8 | ○ | ○ | Δ | ○ | ○ |
| Embodiment 9 | ⊚ | ○ | ○ | ○ | ○ |
| Comparative Example 1 | ⊚ | ○ | Δ | X | X |

As shown in Table 2, the acrylic resin was added to eliminate cracks duo to the phenolic resin, such that the composition of the present invention has improved attachment to a substrate without cracks under electroplating.

The positive photosensitive resin composition has great attachment capability and great tolerance to electroplating. Further, the positive photosensitive resin composition is applicable to a semi-additive process for forming tiny wirings. Moreover, the positive photosensitive resin composition is applicable to form wirings with great wiring profile. Hence, the positive photosensitive resin composition meets requirements in industry.

The invention has been described using exemplary preferred embodiments. However, it is to be understood that the scope of the invention is not limited to the disclosed arrangements. The scope of the claims, therefore, should be accorded the broadest interpretation, so as to encompass all such modifications and similar arrangements.

## Claims

1. A positive photosensitive resin composition, comprising:
20 to 40 wt% of an alkali soluble phenolic resin based on total weight of the positive photosensitive resin composition, wherein the alkali soluble phenolic resin has an average molecular weight of 8000 to 30000;
5 to 20 wt% of an alkali soluble acrylic resin based on the total weight of the positive photosensitive resin composition, wherein the alkali soluble acrylic resin has an average molecular weight of 5000 to 55000;
1 to 15 wt% of a photosensitive compound having quinone diazide based on the total weight of the positive photosensitive resin composition; and
a solvent.

2. The positive photosensitive resin composition of claim 1, wherein the alkali soluble acrylic resin comprises units of formulae (I), (II) and (III):

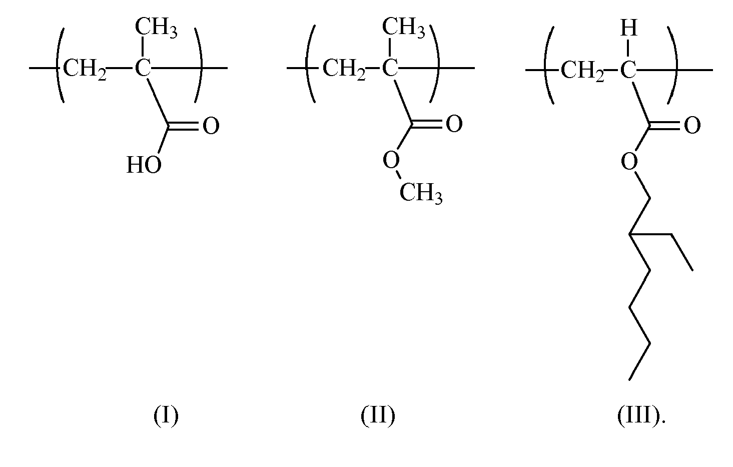

3. The positive photosensitive resin composition of claim 2, wherein 10 to 30 wt% of the alkali soluble acrylic resin is unit (I); 50 to 80 wt% of the alkali soluble acrylic resin is unit (II); and 10 to 20 wt% of the alkali soluble acrylic resin is unit (III).

4. The positive photosensitive resin composition of one of the preceding claims, wherein the average molecular weight of the alkali soluble phenolic resin is 10000 to 25000.

5. The positive photosensitive resin composition of one of the preceding claims, wherein the average molecular weight of the alkali soluble acrylic resin is 20000 to 35000.

6. The positive photosensitive resin composition of one of the preceding claims, wherein the photosensitive compound having quinone diazide is formed from naphthoquinone diazide salfonic acid and a compound of formula (C-1), (C-2), (C-3) or (C-4):

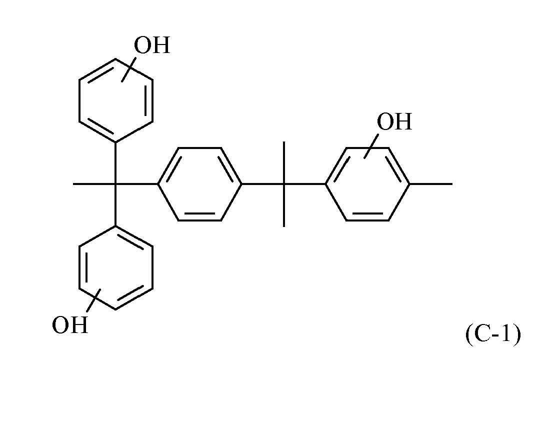

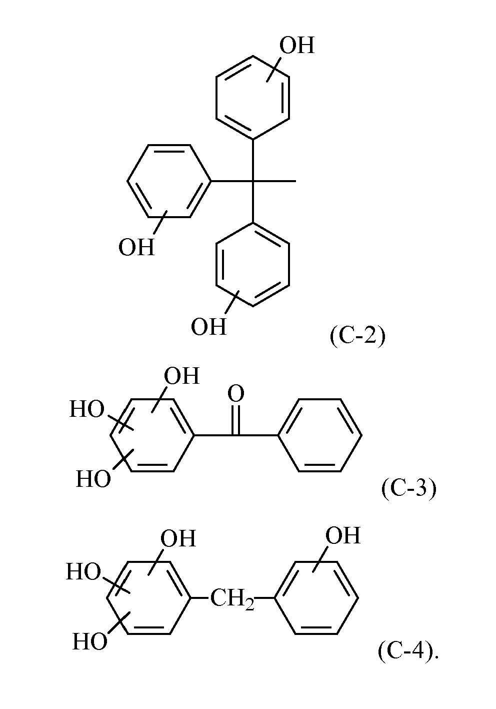

7. The positive photosensitive resin composition of claim 6, wherein the naphthoquinone diazide salfonic acid is 1,2-naphthoquinone diazide-4-salfonic acid or 1,2-naphthoquinone diazide-5-salfonic acid.

8. A positive photosensitive resin composition for a semi-additive process, comprising:
20 to 40 wt% of an alkali soluble phenolic resin based on total weight of the positive photosensitive resin composition, wherein the alkali soluble phenolic resin has an average molecular weight of 8000 to 30000;
5 to 20 wt% of an alkali soluble acrylic resin based on the total weight of the positive photosensitive resin composition, wherein the alkali soluble acrylic resin has an average molecular weight of 5000 to 55000;
1 to 15 wt% of a photosensitive compound having quinone diazide based on the total weight of the positive photosensitive resin composition; and
a solvent.

9. The positive photosensitive resin composition of claim 8, wherein the alkali soluble acrylic resin comprises units of formulae (I), (II) and (III):

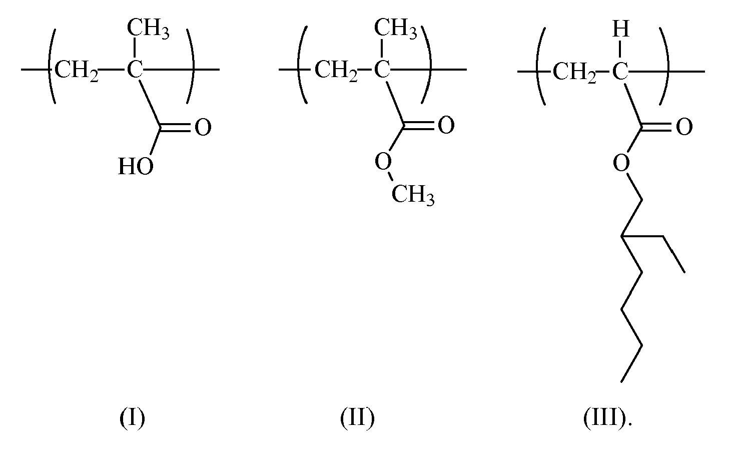

10. The positive photosensitive resin composition of claim 9, wherein 10 to 30 wt% of the alkali soluble acrylic resin is unit (I); 50 to 80 wt% of the alkali soluble acrylic resin is unit (II); and 10 to 20 wt% of the alkali soluble acrylic resin is unit (III).

11. The positive photosensitive resin composition of one of claims 8 to 10, wherein the average molecular weight of the alkali soluble phenolic resin is 10000 to 25000.

12. The positive photosensitive resin composition of one of claims 8 to 11, wherein the average molecular weight of the alkali soluble acrylic resin is 20000 to 35000.

13. The positive photosensitive resin composition of one of claims 8 to 12, wherein the photosensitive compound having quinone diazide is formed from naphthoquinone diazide salfonic acid and a compound of formula (C-1), (C-2), (C-3) or (C-4):

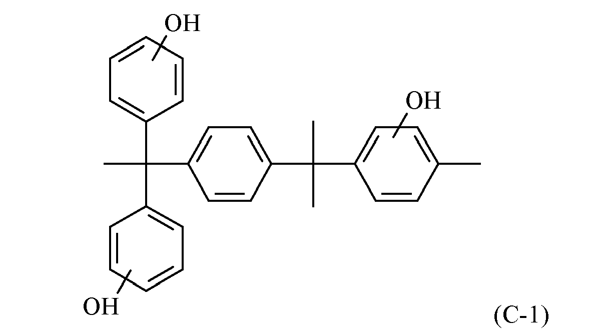

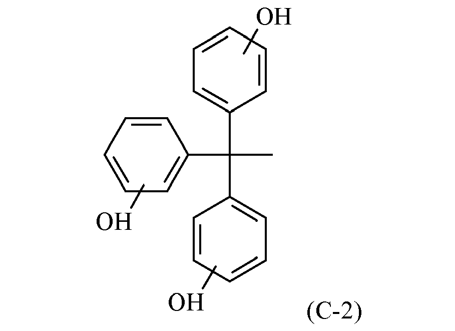

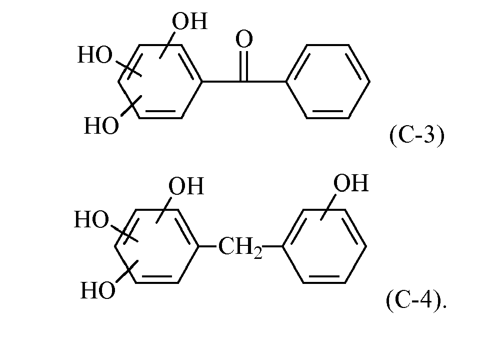

14. The positive photosensitive resin composition of claim 13, wherein the naphthoquinone diazide salfonic acid is 1,2-naphthoquinone diazide-4-salfonic acid or 1,2-naphthoquinone diazide-5-salfonic acid.
